# EUROPEAN PATENT SPECIFICATION

(11) **EP 0 716 455 B1**
(45) Date of publication and mention of the grant of the patent: **01.03.2000**
(21) Application number: 95308754.1
(22) Date of filing: 05.12.1995
(51) Int. Cl.: H01L 29/423, H01L 21/28, H01L 29/49, H01L 21/8238

(54) **Dual gate formation**
Doppel-Gateherstellung
Fabrication de double grille

(30) Priority: 09.12.1994 US 353471
(43) Date of publication of application: 12.06.1996
(73) Proprietor: AT&T Corp., New York, NY 10013-2412 (US)
(72) Inventor: Lee, Kuo-Hua, Orlando, Florida 32836 (US); Yu, Chen-Hua Douglas, Orlando, Florida 32836 (US)
(74) Representative: Watts, Christopher Malcolm Kelway, Dr.

(56) References cited:
- JP-A- 59 124 161
- US-A- 4 745 079
- US-A- 4 890 141
- PATENT ABSTRACTS OF JAPAN vol. 11, no. 292 (E-543) 19 September 1987 & JP-A-62 092 360 (TOSHIBA) 27 April 1987
- RESEARCH DISCLOSURE vol. 326, no. 030, 10 June 1991, EMSWORTH, GB, ANONYMUS 'Low resistivity stack for dual doped poly-silicon gate electrode - in which dual work function poly-silicon is deposited by CVD on substrate comprising gate dielectric on silicon wafer'

## Description

### Technical Field

This invention relates to a method of manufacturing a semiconductor integrated circuits and their manufacture.

### Background of the Invention

Those who manufacture MOS integrated circuits are utilizing designs in which both n⁺ and p⁺ gates are contained within the same integrated circuit.

Unfortunately, when an n⁺ gate contacts a p⁺ gate, counterdoping may occur and a region of poor conductivity may occur where the n⁺ and the p⁺ gate contact each other.

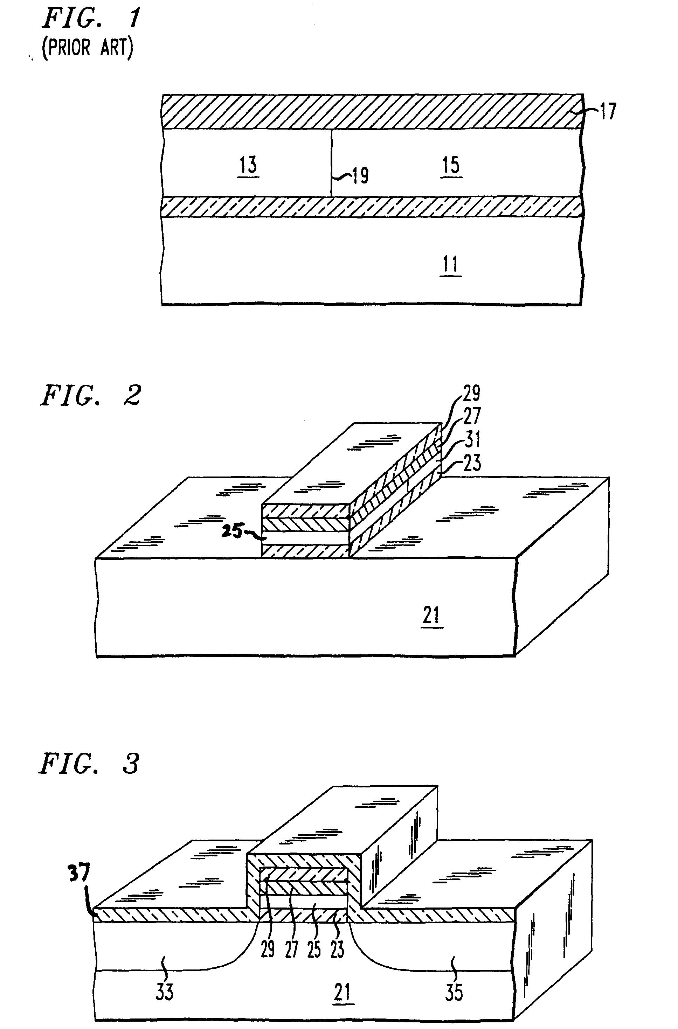

An attempt at solving the problem is depicted in FIG. 1. In FIG. 1, reference numeral 11 denotes a substrate which may, typically, be silicon. Reference numeral 13 denotes a gate, made from patterned, n⁺ doped polysilicon. Reference numeral 15 denotes a p⁺ doped patterned polysilicon. Typically, gates 13 and 15 are patterned together from the same blanket layer of polysilicon, although each has been doped separately while the other has been masked. There is an opportunity for counterdoping at boundary 19 between gates 13 and 15. Layer 17 is made from titanium nitride. Titanium nitride layer 17 acts as a shunt over gates 13 and 15 and preserves conductivity across boundary 19 where an n⁺ - p⁺ diode exists. Unfortunately, titanium nitride layer 17 is easily oxidized, and its conductivity thereby substantially reduced if thermal processing temperatures go to 800°C or above.

A structure as described above is disclosed in US-A-4745079, except that the material of layer 42, which corresponds to layer 17 of FIG. 1 is not specified.

US-A-4890141 (corresponding to the preamble of claim 1) discloses a CMOS device including a TiN local interconnect layer for electrically connecting an n + doped polysilicon region to a p + doped polysilicon region, similar to the FIG. 1 prior art depiction illustrates in this application.

JP-A-59124161 discloses an MIS-type FET including an n + poly region 11 and a p + poly region 12 disposed in a contiguous relationship across the top surface of a gate oxide 13.

Research Disclosure (1991) no. 326 discloses a low resistivity stack gate electrode structure where a layer of TiN is interposed between a lower layer of polysilicon and an upper layer of titanium disilicide. The TiN layer is used as a conductor and also provides a dopant barrier between the layers.

Those concerned with the development of integrated circuits have consistently sought for methods to preserve conductivity across the n⁺/ p⁺ gate boundary despite the problems posed by subsequent thermal processing. Furthermore, those concerned with the development of integrated circuits have continually sought methods of reducing thermal budgets.

### Summary of the Invention

The above problems are solved by the method as defined in claim 1.

### Brief Description of the Drawings

FIG. 1 is a cross-sectional view of the typical prior art device.

FIGS. 2-5 are partially cross-sectional, partially perspective drawings showing an illustrative embodiment of the present invention.

### Detailed Description

In FIG. 2, reference numeral 21 denotes a substrate which, typically, may be silicon, doped silicon, epitaxial silicon, etc. In general, the term "substrate" is used to refer to a body of material upon which other bodies or layers of material may be subsequently formed. Formed atop substrate 21 is gate oxide layer 23; n⁺ polysilicon gate layer 25 is formed atop gate oxide 23. p⁺ doped polysilicon gate 31 is also formed atop gate oxide 23. p⁺ gate 31 contacts n⁺ gate 25. Titanium nitride layer 27 is located on top of gate 25 and 31. Titanium nitride layer 27 contacts both gates 25 and 31 and electrically shunts them. Layer 29 is a dielectric, desirably formed from plasma enhanced tetraethoxysilane (PETEOS). Applicant has determined that dielectrics formed from low pressure CVD TEOS are unsatisfactory because the dielectric deposition process causes undue oxidation of titanium nitride layer 25 during deposition. Silicon nitride has also been found to be unsuitable for layer 29 because subsequent etching of the silicon nitride/polysilicon/oxide stack is very difficult. Other acceptable dielectrics for layer 29 may be spin on glass (SOG) or Low Temperature Oxides (desirably formed below 400°C).

The process for creating the structure of FIG. 2, typically, involves depositing a blanket layer of oxide over substrate 21. Next, a blanket layer of polysilicon is deposited over the oxide layer. The polysilicon is then doped utilizing p⁺ and n⁺ dopants in the appropriate places. Next, blanket layers of titanium nitride and PETEOS are deposited. The PETEOS layer may be patterned using a gate mask. The patterned PETEOS is utilized as a hard mask to pattern the titanium nitride, polysilicon, and oxide layers, thereby producing the structure of FIG. 2. It will be noted that titanium nitride layer 27 is now covered by protective PETEOS layer 29 and that the plasma process utilized to form PETEOS layer 29 has not caused any appreciable oxidation of titanium nitride shunt layer 27.

Turning to FIG. 3, LDD (lightly doped drain) source and drain implants 33 and 35 are performed. Next, a blanket layer of PETEOS or silicon nitride or TEOS denoted by reference numeral 37 is formed. Next, an (optional) implant thermal activation of the LDD implant step may be performed.

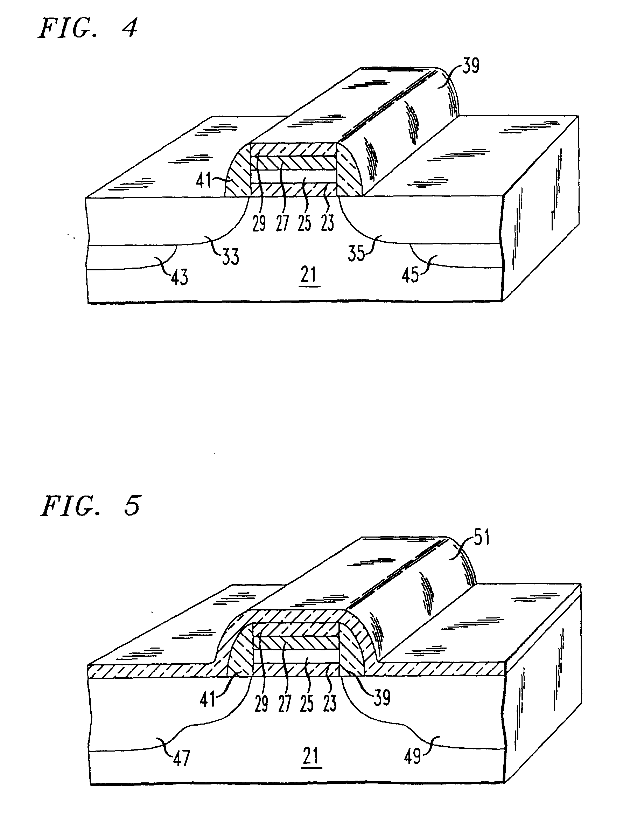

Next turning to Fig. 4, blanket layer 37 is an isotropically etched to produce spacers 39 and 41. Implants 43 and 45, designed to complete the source-drain regions may also be performed. It will be thus noted that the titanium nitride layer 27 is effectively encapsulated and protected by layer 29 and spacers 39 and 41.

Turning to FIG. 5, lightly-doped source structures formed by implantations 33 and 43 have been designated by a single reference numeral 47. Similarly, lightly-doped drain structure designated by reference numerals 35 and 45 have been designated by a separate reference numeral 49. Next, a blanket dielectric layer 51, which may be a bilayer of, for example, TEOS beneath a material chosen from the group of: BPTEOS or LPCVD TEOS or PETEOS, is formed. After dielectric 51 has been formed, it is smoothed by flowing it at a temperature of between 800°C and 900°C. The thermal smoothing of dielectric 51 also simultaneously accomplishes an annealing of source/drain regions 47 and 49. The thermal smoothing step is performed in an atmosphere with no more than 2% oxygen. Because of the minimal quantity of oxygen present temperatures as high as 900°C may be used without risk of damage to layer 27. Thus, the same thermal processing step at this point of the process simultaneously smooths dielectric 51 while accomplishing a source/drain activation at the same time. Thus, thermal budget is reduced. Furthermore, the thermal heating step at this point of the process also prevents out-diffusion of boron dopant from those portions of substrates 21 which are doped with boron because no source/drain contact windows have been opened. (If source/drain contact windows had been opened, a thermal, processing step would induce some boron present in substrate 21 to out-diffuse.)

From this point further processing may continue, such as the opening of windows to source and drain regions, filling of the windows with conductive material, deposition of further interlevel dielectrics and conductors, etc.

## Claims

1. A method of integrated circuit fabrication comprising:
forming an oxide layer (23) upon a substrate (21);
forming a polysilicon gate layer upon said oxide layer;
doping a first portion of said polysilicon gate layer with n-type dopant (25);
doping a second portion of said polysilicon gate layer with p-type dopant (31);
forming a layer of titanium nitride (27) upon said polysilicon gate layer;
forming a layer of first dielectric material (29) upon said layer of titanium nitride; CHARACTERISED IN THAT said first dielectric material is chosen from the group consisting of PETEOS, SOG and LTO; and in that said method further includes:
patterning said first dielectric layer (29) by at least partially etching said first dielectric layer (29) in the presence of a patterned resist;
patterning said titanium nitride layer (27), and said polysilicon gate layer (25) and said oxide layer (23) using the patterned first dielectric layer as a mask (29), thereby exposing a portion of said substrate and whereby an n-doped polysilicon gate (25) adjacent a p-doped polysilicon gate (31) is defined, these gates being shunted by the patterned titanium nitride layer (27);
forming a blanket layer (37) of a second dielectric material over said gates and over the exposed portion of said substrate; and
an isotropically etching said blanket layer to form spacers (41, 39) adjacent said n-doped gate and said p-doped gate.

2. The method of claim 1 further including the steps of:
forming source and drain regions (47, 49) by embedding dopants in said source and drain regions;
forming a blanket layer of undoped oxide (51) over said gate and said source and drain regions;
forming a blanket layer of doped oxide over said layer of undoped oxide;
performing a thermal heating step at a temperature between 800°C and 900°C to thereby simultaneously activate said dopants and smooth said doped dielectric; and
opening windows through both said dielectrics, thereby exposing said source and drain regions.

3. The method of claim 1 wherein said spacers (41, 39) are formed from a material chosen from the group consisting of PETEOS, silicon nitride and TEOS.

## Patentansprüche

1. Verfahren zur Herstellung von integrierten Schaltungen mit den folgenden Schritten:
Ausbilden einer Oxidschicht (23) auf einem Substrat (21);
Ausbilden einer Polysilizium-Gateschicht auf der Oxidschicht;
Dotieren eines ersten Teils der Polysilizium-Gateschicht mit n-Dotierungsstoff (25);
Dotieren eines zweiten Teils der Polysilizium-Gateschicht mit p-Dotierungsstoff (31);
Ausbilden einer Schicht aus Titannitrid (27) auf der Polysilizium-Gateschicht;
Ausbilden einer Schicht aus erstem dielektrischem Material (29) auf der Titannitridschicht, dadurch gekennzeichnet, daß das erste dielektrische Material aus der Gruppe bestehend aus PETEOS, SOG und LTO ausgewählt wird; und daß das Verfahren weiterhin die folgenden Schritte umfaßt:
Strukturieren der ersten dielektrischen Schicht (29) durch mindestens teilweises Ätzen der ersten dielektrischen Schicht (29) unter Anwesenheit eines strukturierten Resists;
Strukturieren der Titannitridschicht (27) und der Polysilizium-Gateschicht (25) und der Oxidschicht (23) unter Verwendung der ersten dielektrischen Schicht als Maske (29), wodurch ein Teil des Substrats freigelegt wird und ein n-dotiertes Polysilizium-Gate (25) neben einem p-dotierten Polysilizium-Gate (31) definiert wird, wobei diese Gates durch die strukturierte Titannitridschicht (27) überbrückt werden;
Ausbilden einer unstrukturierten Schicht (37) aus einem zweiten dielektrischen Material über den Gates und über dem freigelegten Teil des Substrats; und
anisotropisches Ätzen der unstrukturierten Schicht zur Bildung von Abstandsschichten (41, 39) neben dem n-dotierten Gate und dem p-dotierten Gate.

2. Verfahren nach Anspruch 1, weiterhin mit den folgenden Schritten:
Ausbilden von Source- und Drainbereichen (47, 49) durch Einbetten von Dotierungsstoffen in den Source- und Drainbereichen;
Ausbilden einer unstrukturierten Schicht aus undotiertem Oxid (51) über dem Gate und den Source- und Drainbereichen;
Ausbilden einer unstrukturierten Schicht aus dotiertem Oxid über der Schicht aus undotiertem Oxid;
Durchführen eines thermischen Erhitzungsschritts bei einer Temperatur zwischen 800°C und 900°C, um dadurch gleichzeitig die Dotierungsstoffe zu aktivieren und das dotierte Dielektrikum zu glätten; und
Öffnen von Fenstern durch beide der Dielektrika, wodurch die Source- und Drainbereiche freigelegt werden.

3. Verfahren nach Anspruch 1, wobei die Abstandsschichten (41, 39) aus einem Material gebildet werden, das aus der Gruppe bestehend aus PETEOS, Siliziumnitrid und TEOS ausgewählt wird.

## Revendications

1. Procédé de fabrication de circuits intégrés comprenant :
la formation d'une couche d'oxyde (23) sur un substrat (21) ;
la formation d'une couche de grille de polysilicium sur ladite couche d'oxyde ;
le dopage d'une première partie de ladite couche de grille de polysilicium avec des impuretés de type N (25) ;
le dopage d'une deuxième partie de ladite couche de grille de polysilicium avec des impuretés de type P (31) ;
la formation d'une couche de nitrure de titane (27) sur ladite couche de grille de polysilicium ;
la formation d'une couche de première matière diélectrique (29) sur ladite couche de nitrure de titane, CARACTERISE EN CE QUE ladite première matière diélectrique est choisie dans le groupe consistant en PETEOS, SOG et LTO ; et en ce que ledit procédé comporte en outre :
l'application d'un motif sur ladite première couche diélectrique (29) en gravant au moins partiellement ladite première couche diélectrique (29) en présence d'un résist à motif ;
l'application d'un motif sur ladite couche de nitrure de titane (27), et ladite couche de grille de polysilicium (25) et ladite couche d'oxyde (23) en utilisant la première couche diélectrique à motif comme masque (29), exposant ainsi une partie dudit substrat et par laquelle une grille de polysilicium à dopage N (25) adjacente à une grille de polysilicium à dopage P (31) est définie, ces grilles étant shuntées par la couche de nitrure de titane à motif (27) ;
la formation d'une couche de couverture (37) d'une deuxième matière diélectrique par-dessus lesdites grilles et par-dessus la partie exposée dudit substrat ; et
la gravure anisotrope de ladite couche de couverture en vue de former des entretoises (41, 39) adjacentes à ladite grille à dopage N et ladite grille à dopage P.

2. Procédé selon la revendication 1, comportant en outre les étapes de :
formation de régions de source et de drain (47, 49) en incrustant des impuretés dans lesdites régions de source et de drain ;
formation d'une couche de couverture d'oxyde non dopé (51) par-dessus ladite grille et lesdites régions de source et de drain ;
formation d'une couche de couverture d'oxyde dopé par-dessus ladite couche d'oxyde non dopé ;
exécution d'une étape de chauffage thermique à une température entre 800°C et 900°C en vue d'activer simultanément lesdites impuretés et lisser ledit diélectrique dopé ; et
ouverture de fenêtres à travers lesdits deux diélectriques, exposant ainsi lesdites régions de source et de drain.

3. Procédé selon la revendication 1, dans lequel lesdites entretoises (41, 39) sont formées à partir d'une matière choisie dans le groupe consistant en PETEOS, nitrure de silicium et TEOS.
